# EUROPEAN PATENT APPLICATION

(11) **EP 4 836 641 A1**
(43) Date of publication of application: **04.11.2026**
(21) Application number: 25213128.9
(22) Date of filing: 03.11.2025
(51) Int. Cl.: H10F 77/20, H10F 19/90

(54) **BACK CONTACT PHOTOVOLTAIC CELL AND PHOTOVOLTAIC MODULE**

(30) Priority: 30.04.2025 CN 202510571290
(71) Applicant: Jinko Solar (Haining) Co., Ltd., Haining City, Zhejiang (CN)
(72) Inventor: QIU, Lifeng, Haining City, Zhejiang Province (CN); YANG, Jie, Haining City, Zhejiang Province (CN); XIA, Zhipeng, Haining City, Zhejiang Province (CN); HUANG, Jide, Haining City, Zhejiang Province (CN); LIU, Changming, Haining City, Zhejiang Province (CN); ZHANG, Xinyu, Haining City, Zhejiang Province (CN); JIN, Hao, Haining City, Zhejiang Province (CN)
(74) Representative: Balder IP Law, S.L.

(57) **Abstract**

Disclosed is a back contact photovoltaic cell and a photovoltaic module. The back contact photovoltaic cell (100) includes: a cell base comprising a central region (110) and two edge regions (120) arranged on two opposing sides of the central region (110); a plurality of first fingers (210) and a plurality of second fingers (220), wherein the plurality of the first fingers (210) are arranged in the central region (110), and the plurality of second fingers (220) are arranged in the two edge regions (120); at least one middle connection line (310) and a pair of side connection lines (320) disposed in each edge region (120) and electrically connected to the second fingers (220) of the same electropolarity; and a pair of auxiliary connection lines (340) extending in the second direction (Y), the pair of side connection lines (320) having a width greater than that of the pair of auxiliary connection lines (340).

## Description

### TECHNICAL FIELD

Various embodiments of the present disclosure relate to the field of photovoltaic cell technology, and particularly to a back contact photovoltaic cell and a photovoltaic module.

### BACKGROUND

In solar photovoltaic technology, the most distinctive feature of back contact cells is that both the PN junction and the contact metals are disposed on the back side of the back contact cell. The front side of the back contact cell completely avoids shading by metal grid line electrodes, allowing maximum utilization of incident light, reducing optical losses, and resulting in a higher short-circuit current.

In related technologies, back contact cells typically employ busbars to connect fingers of the same electropolarity, and then use solder pads on the busbars to weld to ribbons. However, carriers on the fingers not connected to the solder pads need to first transfer to the busbars and then pass through the solder pads to the ribbons. This transport path is long, leading to low carrier transport efficiency.

Therefore, how to design a back contact photovoltaic cell with high transport efficiency is a problem that needs to be addressed by those skilled in the art.

### SUMMARY

Embodiments of the present disclosure provide a back contact photovoltaic cell and a photovoltaic module, which are at least beneficial for solving the problem of low carrier transport efficiency in the path connecting fingers using busbars.

According to some embodiments of the present disclosure, a back contact photovoltaic cell is provided and includes a cell base. The cell base has a central region and two edge regions arranged on two opposing sides of the central region.

The back contact photovoltaic cell further includes a plurality of first fingers and a plurality of second fingers. The plurality of the first fingers are arranged in the central region, and the plurality of second fingers are arranged in the two edge regions. The plurality of the first fingers extend in a first direction and are arranged at intervals in a second direction that intersects with the first direction. The two edge regions are spaced apart in the second direction. The plurality of second fingers include a plurality of first sets and a plurality of second sets alternately arranged at intervals in the second direction. The second fingers in a same set of the plurality of first sets and the plurality of second sets extend along a same straight line in the first direction and adjacent second fingers in the same set are spaced apart from each other in the first direction. The back contact photovoltaic cell further includes at least one middle connection line and a pair of side connection lines disposed in each of the two edge regions and electrically connected to the second fingers of the same electropolarity, where the at least one middle connection line and the pair of side connection lines extend in the second direction. The pair of the side connection lines is disposed close to two opposing edges of the cell base in the first direction, respectively, and the at least one middle connection line is disposed between the pair of side connection lines in a same edge region. A respective connection line of the at least one middle connection line and the pair of side connection lines is electrically connected to second fingers having a same electropolarity as the respective connection line in the plurality of second fingers. The back contact photovoltaic cell further includes a pair of auxiliary connection lines, disposed close to the two opposing edges, extending in the second direction through the central region and being electrically connected to the pair of side connection lines, respectively. In the first direction, the pair of side connection lines have a width greater than that of the pair of auxiliary connection lines.

According to some embodiments of the present disclosure, a back contact photovoltaic cell is provided. The back contact photovoltaic cell has a central region and two edge regions arranged on two opposing sides of the central region. The back contact photovoltaic cell includes at least one grid line structure including a first grid line structure disposed in the central region and two second grid line structures respectively disposed in the two edge regions. The first grid line structure includes a plurality of first fingers, the plurality of the first fingers extend continuously in a first direction and are arranged at intervals in a second direction intersecting the first direction. The two edge regions are spaced apart in the second direction. The second grid line structure includes at least one first set of second fingers and at least one second set of second fingers alternately arranged at intervals in the second direction. The first set of second fingers and the second set of second fingers respectively include a plurality of second fingers that extend along a same straight line in the first direction and are spaced apart. The back contact photovoltaic cell further includes two connection line structures disposed in the two edge regions, respectively. The two connection line structures respectively include at least one middle connection line and a pair of side connection lines, the at least one middle connection line and the pair of side connection lines extending in the second direction. The pair of the side connection lines are disposed close to two opposing edges of the back contact photovoltaic cell in the first direction, respectively, and the at least one middle connection line is disposed between the pair of side connection lines. A respective connection line of the at least one middle connection line and the pair of side connection lines is electrically connected to second fingers having a same electropolarity as the respective connection line in the at least one first set of second fingers and the at least one second set of second fingers. A pair of auxiliary connection lines, is disposed close to the two opposing edges, extending in the second direction through the central region and being electrically connected to the pair of side connection lines, respectively. In the first direction, the pair of side connection lines have a width greater than that of the pair of auxiliary connection lines.

In some embodiments, in the first direction, the at least one middle connection line has a width greater than that of the pair of side connection lines.

In some embodiments, in the first direction, the at least one middle connection line has a first width W1, the pair of side connection lines has a second width W2; in the second direction, the plurality of first fingers and the plurality of second fingers have a third width W3, satisfying W1>W2>W3, 400µm≥W1≥250µm, 250µm≥W2≥50µm, 50µm≥W3≥15µm.

In some embodiments, the back contact photovoltaic cell further includes a plurality of welding structures being electrically connected to the plurality of first fingers, the at least one middle connection line or the pair of side connection lines.

The plurality of welding structures include a plurality of first welding structures disposed in the two edge regions close to the central region, and a respective first welding structure of the plurality of first welding structures being electrically connected to a connection line having a same electropolarity as the respective first welding structure in the at least one middle connection line and the pair of side connection lines.

The plurality of welding structures further include a plurality of second welding structures disposed in the central region and having a first group of second welding structures having first electropolarity and being electrically connected to first fingers having the first electropolarity in the plurality of first fingers, and a second group of second welding structures having second electropolarity and being electrically connected to first fingers having the second electropolarity in the plurality of first fingers.

In some embodiments, the adjacent second fingers in the same set are spaced apart from each other in the first direction by a gap.

The respective first welding structure has two ends, respectively electrically connected to second fingers having a same electropolarity as the respective first welding structure in two adjacent sets that are closest to the central region in the plurality of first sets and the plurality of second sets, or the respective first welding structure has one end, electrically connected to second fingers having a same electropolarity as the respective first welding structure in a first set that is closest to the central region in the plurality of first sets and the plurality of second sets, and the other end, electrically connected to a first finger having a same electropolarity as the respective first welding structure and being closest to the edge regions in the plurality of first fingers.

The respective first welding structure extends in the second direction from the one end to the other end through the gap between adjacent second fingers having a different electropolarity from the respective first welding structure in a second set that is closest to the central region in the plurality of first sets and the plurality of second sets.

In some embodiments, the plurality of first welding structures include at least one middle welding portion and a pair of side welding portions, the at least one middle welding portion is electrically connected to the at least one middle connection line, respectively, and the pair of side welding portions is electrically connected to the pair of side connection lines, respectively.

In some embodiments, the photovoltaic cell further comprises extension connection lines, each electrically connected a respective side welding portion of the pair of side welding portions to a corresponding side welding portion of the pair of side connection lines.

A distance between the respective side welding portion and a first edge closest to the respective side welding is greater than a distance between the corresponding side connection line and the first edge.

In some embodiments, the extension connection line has a fourth width W4 in the second direction, the side connection line has a second width W2 in the first direction, satisfying W2= W4.

In some embodiments, in the second direction, the plurality of first welding structures have a first length L1, the plurality of second welding structures have a second length L2, and L1 is greater than L2.

In some embodiments, in the second direction, the middle welding portion has a third length L3, the side welding portion has a fourth length L4, where L4 > L3.

In some embodiments, in the second direction, the side welding portion has a fourth length L4, a spacing dimension between adjacent first fingers or adjacent second fingers is a spacing length G, wherein 4×G>L4>2×G.

In some embodiments, in the first direction, the side connection line has a second width W2 and the auxiliary connection line has a fifth width W5, wherein, 250µm≥W2≥50µm, 200µm ≥ W5 ≥ 30µm.

In some embodiments, the plurality of second fingers include a first broken grid, disposed on a side of the respective side welding portion facing the first edge, and a first extension connection finger, extending in the second direction and disposed on the side of the respective side welding portion facing the first edge, and being electrically connected to the broken grid and a second finger having a same electropolarity as the first extension connection finger, respectively.

In some embodiments, the plurality of first fingers include a second broken grid, disposed on a side of the respective side welding portion facing the first edge, and a second extension connection finger, extending in the second direction and disposed on the side of the respective side welding portion facing the first edge, and being electrically connected to the second broken grid and a first finger having a same electropolarity as the second extension connection finger adjacent to the respective side welding portion in the second direction in the plurality of first fingers, respectively.

In some embodiments, two end edges of the cell base extending in the second direction are first edges, and two end edges of the cell base extending along the first direction are second edges.

A distance between a first end of the respective connection line and a corresponding second edge closest to the first end in the second direction is less than a distance from the corresponding second edge to a second finger electrically connected to the respective connection line and closest to the corresponding second edge in the plurality of second fingers.

A distance between a second end of a second finger electrically connected to a respective side connection line in the first direction and a corresponding first edge closest to the second end is less than a distance between the side connection line and the corresponding first edge.

In some embodiments, a respective auxiliary connection line of the pair of auxiliary connection lines is electrically connected to first fingers having a same electropolarity as the respective auxiliary connection line in the plurality of first fingers.

In some embodiments, two end edges of the cell base extending in the second direction are first edges, two end edges of the cell base extending in the first direction are second edges.

A distance between a third end of the first fingers electrically connected to the respective auxiliary connection line and a corresponding first edge closest to the respective auxiliary connection line in the second direction is less than a distance between the auxiliary connection line and the corresponding first edge.

In some embodiments, the pair of auxiliary connection lines and the plurality of first fingers are connected in a crosswise manner.

In some embodiments, at locations where the second fingers are connected to the at least one middle connection line or the pair of side connection lines, the second fingers and the at least one middle connection line or the pair of side connection lines are connected in a crosswise manner.

According to some embodiments of the present disclosure, a photovoltaic module is provided. The photovoltaic module includes at least one cell string formed by connecting a plurality of back contact photovoltaic cells, each of the plurality of back contact photovoltaic cells is the back contact photovoltaic cell according to the abovementioned; ribbons configured for connecting adjacent back contact photovoltaic cells of the plurality of back contact photovoltaic cells; at least one encapsulant film configured to cover surfaces of the plurality of back contact photovoltaic cells; and at least one cover plate disposed on a surface of the at least one encapsulant film away from the plurality of back contact photovoltaic cells.

### BRIEF DESCRIPTION OF THE DRAWINGS

One or more embodiments are illustrated by way of examples and in combination with the figures of the accompanying drawings. These illustrative descriptions do not constitute limitations on the embodiments. The figures in the accompanying drawings do not constitute a proportion limitation unless otherwise stated. To more clearly illustrate the embodiments of the present disclosure or the technical solutions in the prior art, the drawings used in the embodiments will be briefly described below. Obviously, the drawings in the following description are only some embodiments of the present disclosure. For those of ordinary skill in the art, other drawings can be obtained based on these drawings without creative effort.
FIG. 1 is a schematic structural diagram of a back contact photovoltaic cell according to an embodiment of the present disclosure.
FIG. 2 is a schematic structural diagram of a back contact photovoltaic cell according to another embodiment of the present disclosure.
FIG. 3 is a schematic diagram of a finger of a back contact photovoltaic cell according to the embodiments of the present disclosure.
FIG. 4 is a schematic diagram of a photovoltaic module according to an embodiment of the present disclosure.

### DETAILED DESCRIPTION OF THE EMBODIMENTS

As may be seen from the background art, in related technologies, busbars are typically used to connect grid line structures of the same electropolarity and then use welding structures on the busbars to weld to ribbons, thereby reducing the number of welding structures. However, in this structure, carriers on the grid line structures not connected to the welding structures need to first transfer to the busbars and then pass through the welding structures to the ribbons. The carrier transport efficiency in this path is low, thus affecting the photoelectric conversion efficiency of the back contact photovoltaic cell, and the provision of busbars increases the cost of paste. The back contact photovoltaic cell in the embodiments of the present disclosure may be an Interdigitated Back Contact (IBC) photovoltaic cell.

Some embodiments of the present disclosure provide a back contact photovoltaic cell, where the grid line structure in the central region of the cell base is configured as a collecting finger, and the grid line structure in the edge region is configured as a converging finger. The collecting fingers are directly electrically connected to the welding structures, the transmission path for carriers collected by the collecting fingers to the welding structures is short, thereby improving carrier transport efficiency. converging fingers of the same electropolarity are electrically connected to the welding structures via connection lines. A width of a middle connection line connecting more converging fingers is greater than a width of a side connection line disposed on both sides and connecting fewer converging fingers. The middle connection line with a larger width has lower internal resistance, thereby improving the transport efficiency of carriers within the middle connection line, and improving the photoelectric conversion efficiency of the back contact photovoltaic cell.

In the description of the embodiments of the present disclosure, technical terms such as "first," "second," and the like are used only to distinguish between different objects and should not be construed as indicating or implying relative importance or implicitly specifying the quantity, specific sequence, or primary-secondary relationship of the indicated technical features. In the description of the embodiments of the present disclosure, the term "a plurality of" means two or more, unless explicitly and specifically defined otherwise. Similarly, "a plurality of groups" means two or more groups (including two groups), and "a plurality of pieces" means two or more pieces (including two pieces).

Reference in this document to "an embodiment" means that a particular feature, structure, or characteristic described in connection with the embodiment may be included in at least one embodiment of the present disclosure. The appearance of this phrase in various places in the specification does not necessarily refer to the same embodiment, nor is it an independent or alternative embodiment mutually exclusive with other embodiments. Those skilled in the art will explicitly and implicitly understand that the embodiments described herein may be combined with other embodiments.

In the description of the embodiments of the present disclosure, the term "and/or" merely describes an associative relationship between associated objects, indicating that three relationships may exist. For example, "A and/or B" may indicate the following three cases: presence of A only; presence of both A and B; and presence of B only. In addition, the character "/" in this document generally indicates an "or" relationship between the preceding and following associated objects.

In the description of the embodiments of the present disclosure, technical terms indicating orientation or positional relationships, such as "center," "longitudinal," "transverse," "length," "width," "thickness," "upper," "lower," "front," "rear," "left," "right," "vertical," "horizontal," "top," "bottom," "inner," "outer," "clockwise," "counterclockwise," "axial," "radial," "circumferential," and the like, are based on the orientation or positional relationships shown in the accompanying drawings. These terms are used only for ease of describing the embodiments of the present disclosure and simplifying the description, rather than indicating or implying that the referred apparatus or element must have a specific orientation or be constructed and operated in a specific orientation. Therefore, these terms should not be construed as limitations on the embodiments of the present disclosure. For example, if the apparatus or element in the diagram is inverted, then an element described as being "below," "under," "beneath," or "at the bottom of" another element or feature would then be oriented "above" or "on top of" the other element or feature. Thus, the term "below" may encompass both above and below orientations depending on the context, which would be apparent to those of ordinary skill in the art. Materials may be oriented in other ways (e.g., rotated 90 degrees, inverted, flipped), and the spatially relative descriptors used herein should be interpreted accordingly.

In the description of the embodiments of the present disclosure, unless expressly specified and defined otherwise, technical terms such as "install," "connect," "couple," "fix," and the like should be interpreted broadly. For example, the technical term may refer to a fixed connection, a detachable connection, or an integral connection. The technical term may refer to a mechanical connection, an electrical connection, or both. The technical term may refer to a direct connection, an indirect connection through an intermediary, or internal communication between two elements or an interaction relationship between two elements. Those of ordinary skill in the art may understand the specific meanings of the above terms in the embodiments of the present disclosure based on the specific context.

In the drawings corresponding to the embodiments of the present disclosure, the thicknesses and areas of layers are exaggerated for better understanding and ease of description. Furthermore, when describing a component as being formed "substantially" on another component, it means that the component is not formed on the entire surface (or front surface) of the other component, nor is it formed on part of the edge of the entire surface.

In the description of the embodiments of the present disclosure, when a component is described as "comprising" or "including" another component, it does not exclude the presence of other components unless stated otherwise, and other components may also be included. Forming or providing a second component on or above a first component, or forming or providing a second component on a surface of a first component, or forming or providing a second component on a side of a first component, may include embodiments where the first component and the second component are in direct contact, and may also include embodiments where additional components are present between the first and second components such that these components are not in direct contact. For simplicity and clarity, various components may be drawn arbitrarily in different scales. In the drawings, some layers/components may be omitted for simplicity. Unless otherwise specified, forming or providing a second component on a surface of a first component means that the first component and the second component are in direct contact. Herein, the aforementioned "component" may refer to a layer, film, region, portion, structure, etc.

The terminology used in the description of the various embodiments herein is for the purpose of describing particular embodiments only and is not intended to be limiting. As used in the description of the various embodiments and the appended claims, the singular forms "a," "an," and "the" are intended to include the plural forms as well, unless the context clearly indicates otherwise. Herein, a component includes components such as a layer, film, region, plate, etc.

The embodiments of the present disclosure will be described in detail below with reference to the accompanying drawings. However, those of ordinary skill in the art will understand that in the various embodiments of the present disclosure, many technical details are set forth to enable the reader to better understand the present disclosure. However, the claimed technical solutions of the present disclosure may be implemented even without these technical details and based on various changes and modifications of the following embodiments.

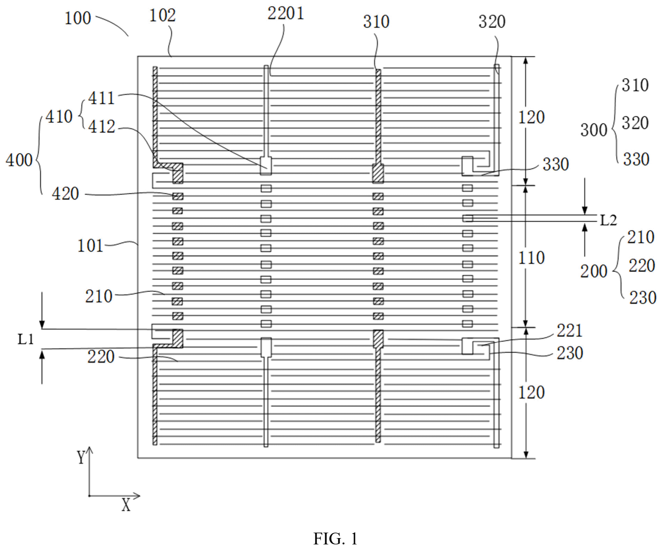

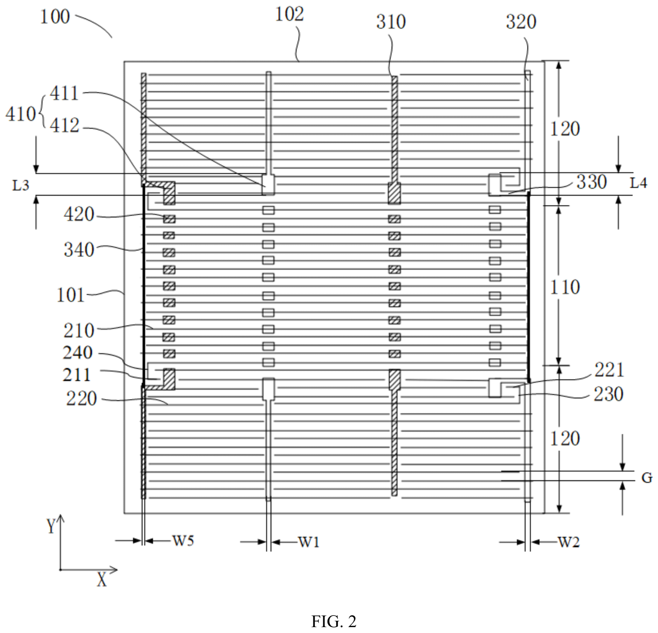

FIGS. 1 and 2 are schematic structural diagrams of back contact photovoltaic cells according to embodiments of the present disclosure.

Referring to FIG. 1, the back contact photovoltaic cell includes a cell base 100, at least one grid line structure 200, and at least one connection line structure 300.

The cell base 100 includes a central region 110 and two edge regions 120 arranged on two opposing sides of the central region 110. For the purpose of illustration, FIG. 1 shows a first direction X and a second direction Y that intersect to the first direction X, where the second direction Y is a direction in which the two edge regions 120 are spaced apart.

The at least one grid line structure 200 includes a plurality of first fingers disposed in the central region 110 and a plurality of second fingers disposed in the two edge areas 120, respectively. In the embodiments of the present disclosure, the first fingers are configured as collecting fingers 210 disposed in the central region 110, and the second fingers are configured as converging fingers 220 disposed in the edge regions 120, as shown in FIG. 1.

The collecting fingers 210 disposed in the central region 110 extend continuously in the first direction X and are arranged at intervals in the second direction Y. The plurality of second fingers includes at least one first set of converging fingers 220 and at least one second set of converging fingers 220 alternately arranged at intervals in the second direction Y. Each of the first set and the second set of converging fingers 220 includes a plurality of converging fingers 220 that extend along a same straight line in the first direction and are spaced apart from each other in the first direction.

The at least one connection line structure 300 is disposed in the edge regions 120. The connection line structure 300 is electrically connected to the converging fingers 220 of the same electropolarity. The connection line structure 300 includes at least one middle connection line 310 and at least one pair of side connection lines 320 in edge regions 120. Each of the at least one middle connection line 310 and the side connection lines 320 extends in the second direction Y. A pair of side connection lines 320 in a same edge region 120 are disposed close to two opposing edges of the cell base 100 in the first direction X, respectively. The at least one middle connection line 310 are disposed between the pair of side connection lines 320.

In the first direction X, a width of the middle connection line 310 is greater than a width of the side connection line 320.

In some embodiments, a back contact photovoltaic cell having a central region 110 and two edge regions 120 arranged on two opposing sides of the central region 120 is provided.

The back contact photovoltaic cell includes at least one grid line structure including a first grid line structure disposed in the central region and two second grid line structures respectively disposed in the two edge regions. The first grid line structure includes a plurality of first fingers 210, the plurality of the first fingers extend continuously in a first direction X and are arranged at intervals in a second direction Y intersecting the first direction. The two edge regions 120 are spaced apart in the second direction Y. The second grid line structure includes at least one first set of second fingers and at least one second set of second fingers alternately arranged at intervals in the second direction. The first set of second fingers and the second set of second fingers respectively include a plurality of second fingers 220 that extend along a same straight line in the first direction and are spaced apart.

The back contact photovoltaic cell further includes two connection line structures disposed in the two edge regions, respectively. The two connection line structures respectively include at least one middle connection line 310 and a pair of side connection lines 320, the at least one middle connection line and the pair of side connection lines extending in the second direction. The pair of the side connection lines 320 are disposed close to two opposing edges of the back contact photovoltaic cell in the first direction, respectively, and the at least one middle connection line 310 is disposed between the pair of side connection lines. A respective connection line of the at least one middle connection line 310 and the pair of side connection lines 320 is electrically connected to second fingers 220 having a same electropolarity as the respective connection line in the at least one first set of second fingers and the at least one second set of second fingers.

The back contact photovoltaic cell further includes a pair of auxiliary connection lines, disposed close to the two opposing edges, extending in the second direction through the central region and being electrically connected to the pair of side connection lines, respectively.

In the first direction, the pair of side connection lines have a width greater than that of the pair of auxiliary connection lines.

In the embodiments of the present disclosure, the grid line structure 200 of the cell base 100 are divided into a plurality of collecting fingers 210 disposed in the central region 110 and a plurality of converging fingers 220 disposed in the edge regions 120. The collecting fingers 210 are directly electrically connected to the welding structures 400, resulting in a shorter transmission path for carriers collected by the collecting fingers 210 to reach the welding structures 400, thereby improving carrier transport efficiency. The converging fingers 220 of the same electropolarity are electrically connected to the welding structures 400 via the connection line structure 300. The middle connection line 310, which connects to more converging fingers 220, has a width greater than that of the side connection lines 320 disposed on both sides, which connect to fewer converging fingers 220. The wider middle connection line 310 has lower internal resistance, thereby improving the transport efficiency of carriers within the middle connection line 310, and enhancing the photoelectric conversion efficiency of the back contact photovoltaic cell. The arrangement of the connection line structure 300 in the edge regions 120 reduces the number of welding structures 400 disposed in the edge regions 120, avoiding issues such as cracking of the cell base 100 due to stress concentration during welding of the welding structures 400 and ribbons, and warping of the cell base 100 caused by different coefficients of thermal expansion between the cell base 100 and the ribbons. This improves the production yield of the back contact photovoltaic cell and extends the service life of the back contact photovoltaic cell.

The following describes the embodiments of the present disclosure in more detail with reference to the accompanying drawings.

FIG. 1 is a schematic structural diagram of a back contact photovoltaic cell according to an embodiment of the present disclosure. For the purpose of illustration, FIG. 1 shows a first direction X and a second direction Y that intersect with each other. In the embodiments of the present disclosure, both the positive and negative electrodes of the back contact photovoltaic cell are disposed on the backside surface of the cell base 100. The back contact photovoltaic cell includes a cell base 100, at least one grid line structure 200, at least one connection line structure 300, and a plurality of welding structures 400.

The cell base 100 is of a rectangular sheet-like structure and has a photoelectric effect. The cell base 100 has a first surface and a second surface opposite to each other in a third direction. The third direction is the thickness direction of the cell base 100 and intersects with both the first direction X and the second direction Y. In the embodiments of the present disclosure, the first surface of the cell base 100 is the light-receiving surface of the back contact photovoltaic cell, and the second surface is the backside surface. The at least one grid line structure 200, the at least one connection line structure 300, and the welding structures 400 are all disposed on the second surface of the cell base 100. In the first direction X, the cell base 100 has two opposing first edges 101. In the second direction Y, the cell base 100 has two opposing second edges 102. The cell base 100 includes the central region 110 and two edge regions 120 disposed on two opposing sides of the central region 110 in the second direction Y, i.e., the two edge regions 120 are respectively close to the opposite second edges 102 of the cell base 100.

In some embodiments, the at least one grid line structure 200, the at least one connection line structure 300, and the welding structures 400 are formed on the second surface of the cell base 100 by a screen printing process.

In some embodiments, the cell base 100 may be obtained by cutting a whole cell into 1/N pieces, i.e., the cell base 100 is an N-segmented cell, where N is a positive integer greater than 1. In other embodiments, the cell base 100 may be a whole cell, i.e., the cell base 100 is a full-size cell.

In some embodiments, the cell base 100 is obtained by cutting a whole cell into two segments, i.e., the cell base 100 is a bisected cell (i.e., a half-cut cell).

In some embodiments, where the cell base 100 is obtained by cutting a whole cell into N segments, the grid line structure 200, the at least one connection line structure 300, and the welding structures 400 are first formed on the surface of the whole cell by a screen printing process, and then the whole cell is cut into the N-segmented cell base 100 of the embodiments of the present disclosure to constitute the back contact photovoltaic cell of the embodiments of the present disclosure. In other embodiments, the cell base 100 is a whole cell, and the grid line structure 200, the at least one connection line structure 300, and the welding structures 400 are formed on the surface of the cell base 100 by a screen printing process to directly constitute the back contact photovoltaic cell of the embodiment of the present disclosure.

The at least one grid line structure 200 is disposed on the second surface of the cell base 100 for collecting and transporting photogenerated carriers, thereby enabling the electrical energy conversion of the back contact photovoltaic cell. Since both the positive and negative electrodes of the back contact photovoltaic cell in the embodiments of the present disclosure are disposed on the backside surface of the cell base 100, the electropolarity of the at least one grid line structure 200 may be either positive or negative. The at least one grid line structure 200 includes a plurality of collecting fingers 210 and a plurality of converging fingers 220. Each of the collecting fingers 210 and the converging fingers 220 extends in the first direction X. The plurality of collecting fingers 210 and the plurality of converging fingers 220 of different electropolarities are distributed at intervals in the second direction Y. In the embodiments of the present disclosure, the collecting fingers 210 are disposed in the central region 110. Each of the collecting fingers 210 is arranged in a continuous linear pattern in the first direction X. Adjacent collecting fingers 210 in the second direction Y have different electropolarities. The converging fingers 220 are disposed in the edge regions 120. A set of converging fingers is formed by a plurality of converging fingers that extend along a same straight line in the first direction and are spaced apart. In each edge region 120, a plurality of the sets is arranged at intervals in the second direction Y. That is, in each set of the converging fingers, adjacent converging fingers 220 extending in the same straight line of the first direction X have a gap 2201 therebetween. In each set of the converging fingers, the converging fingers 220 extending in the same straight line of the first direction X have the same electropolarity. The converging fingers 220 of each set have an electrical polarity that is different from that of the converging fingers 220 in adjacent set in the second direction Y. In the region bordering the central region 110 and the edge regions 120, adjacent collecting fingers 210 and converging fingers 220 in the second direction Y have different electropolarities.

The at least one connection line structure 300 is disposed in the edge regions 120 for collecting carriers transported by the converging fingers 220. The at least one connection line structure 300 in each edge region 120 includes at least one middle connection line 310 and a pair of side connection lines 320. The at least one middle connection line 310 and the pair of side connection lines 320 extend in the second direction Y. The electropolarity of the at least one connection line structure 300 may be either positive or negative, and each connection line structure 300 is electrically connected to the converging fingers 220 of the same electropolarity. In the same edge region 120, two side connection lines 320 are symmetrically disposed at two opposing edges of the edge region 120 in the first direction X, i.e., two side connection lines 320 on both sides are respectively close to the opposite first edges 101 of the cell base 100. The converging fingers 220 and the at least one middle connection line 310 are disposed between the symmetrical side connection lines 320. The at least one middle connection line 310 extends in the second direction Y and is disposed in the gaps 2201 between converging fingers 220 of different electropolarities. The at least one middle connection line 310 is electrically connected to the converging fingers 220 of the same electropolarity disposed in the second direction Y on both sides of the middle connection line 310. Each side connection line 320 extends in the second direction Y and is electrically connected to the converging fingers 220 of the same electropolarity disposed on one side of the side connection line 320.

The side connection lines 320 and the at least one middle connection line 310 are arranged at intervals and are evenly spaced in the first direction X, so that the lengths of the converging fingers 220 connected to each side connection line 320 at both sides are equal, and the lengths of the converging fingers 220 connected to both sides of each middle connection line 310 in the first direction X are equal. The uniform arrangement of the side connection lines 320 and the at least one middle connection line 310 reduces the overall internal resistance of the back contact photovoltaic cell, improves carrier transport efficiency, and thereby enhancing the photoelectric conversion efficiency of the back contact photovoltaic cell.

Furthermore, in the first direction X, each of the at least one middle connection line 310 has a first width W1, and each of the side connection lines 320 has a second width W2, satisfying W1 > W2. Since the side connection lines 320 are disposed at edge positions of the cell base 100 close to the first edges 101, the side connection line 320 is electrically connected to the converging fingers 220 on only one side of the side connection line 320, and each middle connection line 310 is electrically connected to the converging fingers 220 on both sides of the middle connection line 310. Therefore, the total length of the converging fingers 220 electrically connected to the side connection line 320 is less than the total length of the converging fingers 220 electrically connected to the middle connection line 310. The middle connection line 310 needs to transport more carriers compared to the side connection line 320. The middle connection line 310 has a larger width dimension compared to the side connection line 320, which reduces the internal resistance of the middle connection line 310, improves the carrier transport efficiency, and thereby enhances the photoelectric conversion efficiency of the back contact photovoltaic cell. Compared to relevant technologies where the width of the busbar (corresponding to the at least one connection line structure 300 in the embodiments of the present disclosure) connected to the fingers (corresponding to the grid line structure 200 in the embodiments of the present disclosure) is uniform regardless of whether it is wider or narrower, in the present disclosure, based on the total length of the converging fingers 220 connected to the at least one middle connection line 310 and the side connection lines 320 and the total mobility of carriers that need to be transported, the width of each middle connection line 310 is set to be greater than that of each side connection line 320. This, on one hand, improves carrier transport efficiency and thus the photoelectric conversion efficiency of the back contact photovoltaic cell, and on the other hand, saves paste used for making the at least one connection line structure 300, reducing production costs.

In some embodiments, the first width W1 of each middle connection line 310 satisfies 250µm≤W1≤400µm. Preferably, the first width W1 of each middle connection line 310 may be 280µm, 300µm, 350µm, or 370µm.

In some embodiments, the second width W2 of each side connection line 320 satisfies 50µm≤W2≤250µm. Preferably, the second width W2 of each side connection line 320 may be 60µm, 100µm, 150µm, or 200µm.

In some embodiments, in the second direction Y, each of the collecting fingers 210 and the converging fingers 220 has a third width W3, satisfying 15µm≤W3≤50µm. Preferably, the third width W3 may be 25µm, 30µm, 35µm, or 40µm.

Furthermore, at locations where converging fingers 220 of the same electropolarity are connected to the at least one middle connection line 310 or the side connection lines 320, the converging fingers 220 and the at least one middle connection line or the side connection lines 300 are connected in a crosswise manner.

In some embodiments, in the first direction X, for a converging finger 220 connected to a side connection line 320, the distance between an end of the converging finger 220 close to the first edge 101 and the first edge 101 is less than the distance between the side connection line 320 and the first edge 101. In other words, the end of the converging finger 220 protrudes beyond the side connection line 320 of the same electropolarity to which it is connected. In the second direction Y, the distance between an end of each of the side connection lines 320 and the at least one middle connection line 310 close to the second edge 102 and the second edge 102 is less than the distance between the converging finger 220 of the same electropolarity that is closest to the second edge 102 and the second edge 102. In other words, the end of each of the side connection lines 320 and the at least one middle connection line 310 protrudes beyond the converging finger 220 of the same electropolarity that is closest to the second edge 102 and to which it is connected. That is, the converging fingers 220 extending in the first direction X pass through the at least one middle connection line 310 and the side connection line 320 (which is closest to the first edge 101) to which the converging fingers 220 are connected, and the at least one middle connection line 310 and the side connection line 320 extending in the second direction Y pass through the converging fingers 220 (which are closest to the second edge 102) to which the at least one middle connection line 310 and the side connection line 320 are connected. This cross-connection structure ensures the connection effectiveness between the converging fingers 220 and the at least one connection line structure 300, avoiding issues of non-connection or poor connection caused by printing errors.

Furthermore, in the second direction Y, the end of the middle connection line 310 close to the second edge 102 is spaced apart from the converging finger 220 of different electropolarity that is closest to the second edge 102. In other words, the end of the middle connection line 310 close to the second edge 102 does not protrude beyond the straight line on which the converging finger 220 of different electropolarity and closest to the second edge 102 lies. That is, the middle connection line 310 and the converging finger 220 of different electropolarity closest to the second edge 102 are disconnected from each other in the first direction X. This disconnected structure prevents short circuits that might occur if the middle connection line 310 and the converging finger 220 closest to the second edge 102 are connected due to printing errors or other reasons.

A plurality of welding structures 400 are disposed on the second surface of the cell base 100. The welding structures 400 are electrically connected to the collecting fingers 210 or the at least one connection line structure 300. The welding structures 400 are used for welding with ribbons, exporting the current generated by the back contact photovoltaic cell to an external circuit, and achieving series or parallel connections between back contact photovoltaic cells to form a complete current path.

The welding structures 400 include first welding structures 410 and second welding portions 420. The first welding structures 410 are disposed in the edge regions 120 and are electrically connected to the at least one connection line structure 300 in the edge regions 120. The second welding structures 420 are disposed in the central region 110 and are electrically connected to the collecting fingers 210 in the central region 110. Carriers collected by the converging fingers 220 are transmitted to the external circuit sequentially through the at least one connection line structure 300 and the first welding structures 410, so as to reduce the number of welding structures 400 disposed in the edge regions 120, avoid issues such as cracking of the cell base 100 due to stress concentration during welding of the welding structures 400 and ribbons, and warping of the cell base 100 caused by different coefficients of thermal expansion between the cell base 100 and the ribbons, thereby improving the production yield of the back contact photovoltaic cell and prolonging the service life. Carriers collected by the collecting fingers 210 are directly transmitted to the external circuit through the second welding structures 420, and such a transmission path is shorter, thus improving carrier transport efficiency, and thereby enhancing the photoelectric conversion efficiency of the back contact photovoltaic cell in the embodiments of the present disclosure.

The first welding structures 410 and the second welding structures 420 of the same electropolarity are arranged at intervals in the second direction Y, facilitating welding with ribbons extending in the second direction Y and having the same electropolarity. In some embodiments of the present disclosure, the second welding structures 420 of the same electropolarity are uniformly distributed based on the number of first welding structures 410 of the same electropolarity, so that the numbers of second welding portions 420 corresponding to each first welding structure 410 of the same electropolarity are the same. In some embodiments of the present disclosure, adjacent second welding portions 420 of different electropolarity in the first direction X are uniformly spaced in the first direction X, and adjacent first welding structures 420 of the same electropolarity in the second direction Y are uniformly spaced in the first direction Y, so as to make the distribution of the second welding structures 420 in the central region 110 more uniform and further avoid warping or cracking of the cell base 100 caused by welding.

The first welding structures 410 are arranged at equal intervals in the first direction X, facilitating uniform internal stress distribution in the cell base 100 after the first welding structures 410 and the second welding structures 420 are welded to ribbons, avoiding warping or cracking of the cell base 100 due to localized stress concentration.

The first welding structures 410 are disposed at end positions of the at least one connection line structure 300 close to the central region 110. That is, the first welding structures 410 are disposed on the side of the edge regions 120 away from the second edges 102, further preventing warping or cracking at the edge positions of the cell base 100.

Furthermore, in the first direction X, the width dimensions of the first welding structure 410 and the second welding structures 420 are equal, facilitating simultaneous formation during the printing process in production.

In the second direction Y, the first welding structure 410 has a first length L1, and the second welding structure 420 has a second length L2, satisfying L1 > L2. The first welding structure 410 include at least one middle welding portion 411 and a pair of side welding portions 412. The total length of all the converging fingers 220 electrically connected to each middle welding portion 411 is less than the length of the collecting finger 210 electrically connected to each second welding structure 420. The total length of all the converging fingers 220 electrically connected to each side welding portion 412 is greater than the length of the collecting finger 210 electrically connected to each second welding structure 420. The length dimension of the first welding structure 410 is greater than that of the second welding structure 420, providing high carrier transport efficiency.

In some embodiments, the first length L1 of the first welding structure 410 satisfies 0.4mm≤L1≤2.1mm. Preferably, the first length L1 of the first welding structure 410 may be 0.8mm, 1mm, 1.2mm, or 1.4mm.

In some embodiments, the second length L2 satisfies 0.08mm≤L2≤0.4mm. Preferably, the second length L2may be 0.15mm, 0.2mm, 0.25mm, or 0.3mm.

Furthermore, in the second direction Y, each middle welding portion 411 has a third length L3, and each side welding portion 412 has a fourth length L4, satisfying L3 < L4. Since the side welding portions 412 are positioned closer to the edge of the cell base 100 and the length dimension of the side welding portion 412 is larger than that of the second welding structure 420, increasing the length dimension of the side welding portions 412 increases the welding pull force after the side welding portions 412 are connected to the ribbon, improving the overall structural stability of the back contact photovoltaic cell.

In some embodiments, the third length L3 satisfies 0.4mm≤L3≤0.8mm. Preferably, the third length L3 may be 0.5mm, 0.6mm, 0.65mm, or 0.7mm.

In some embodiments, the fourth length L4 satisfies 0.8mm≤L4≤2.1mm. Preferably, the fourth length L4 may be 0.95mm, 1mm, 1.2mm, or 1.4mm.

Furthermore, in the second direction Y, the spacing dimension between adjacent collecting fingers 210 or between adjacent converging fingers 220 is a spacing length g, and the length dimension of the side welding portions 412 is the fourth length L4, satisfying 4g>L4>2g. The length dimension of the side welding portion 412 is greater than twice the spacing length g and less than four times the spacing length g, allowing the side welding portion 412 to pass through the gaps 2201 between converging fingers of different electropolarities and electrically connect to the converging fingers 220 or collecting fingers 210 of the same electropolarity. The side welding portion 412 may be directly connected to the converging fingers 220 or collecting fingers 210, shortening the carrier transport path length, improving carrier transport efficiency, and thereby enhancing the photoelectric conversion efficiency of the back contact photovoltaic cell.

In some embodiments, the spacing length g between adjacent collecting fingers 210 or between adjacent converging fingers 220 satisfies 0.5mm≤ g ≤ 2mm. Preferably, the spacing length g between adjacent collecting fingers 210 or between adjacent converging fingers 220 may be 0.8mm, 0.92mm, 1mm, or 1.2mm.

The first welding structures 410 include the middle welding portions 411 and the side welding portions 412. The middle welding portions 411 are electrically connected to the at least one middle connection line 310. The side welding portions 412 are electrically connected to the side connection lines 320. The middle welding portions 411 and the side welding portions 412 disposed in the same edge region are arranged at intervals in the first direction X.

In the first direction X, the distance between a side welding portion 412 and the corresponding first edge 101 is greater than the distance between the side connection line 320 and the first edge 101. This causes the side welding portion 412 farther away from the first edge 101 than the side connection line 320, further preventing warping or cracking at the edge positions of the cell base 100.

The at least one connection line structure 300 further include at least one extension connection line 330. The extension connection line 330 extends in the first direction X and is disposed between the side welding portion 412 and the side connection line 320. Two ends of at least one extension connection line 330 are electrically connected to a respective side welding portion 412 and a respective side connection line 320, respectively.

Furthermore, in the second direction Y, the extension connection line 330 has a fourth width W4. The second width W2 of the side connection line 320 satisfies W2=W4. The width dimension of the extension connection lines 330 is equal to that of the side connection lines 320, avoiding an increase in the overall internal resistance of the side connection lines 320 and the extension connection lines 330 due to an excessively small width dimension of the extension connection lines 330, which would reduce the carrier transport efficiency of the side connection lines 320.

In some embodiments, the converging fingers 220 further include broken grids 221 disposed on the side of the side welding portions 412 close to the first edges 101, and extension connection fingers 230 for connecting the broken grids 221 to the converging fingers 220. The broken grid 221 and the converging finger 220 of the same electropolarity extend in the first direction X. The extension connection fingers 230 extend in the second direction Y and electrically connect a broken grid 221 to an adjacent converging finger 220 of the same electropolarity. The arrangement of the broken grids 221 and the extension connection fingers 230 increases the coverage of the grid line structure 200 on the surface of the cell base 100, thereby improving the photoelectric conversion efficiency of the back contact photovoltaic cell.

In some embodiments, the collecting fingers 210 further include broken grids 211 disposed on the side of the side welding portions 412 close to the first edges 101, and extension connection fingers 240 for connecting the broken grids 211 to the collecting fingers 210. The broken grid 211 and the connecting finger 210 of the same electropolarity extend in the first direction X. The extension connection fingers 240 extend in the second direction Y and electrically connect a broken grid 211 to an adjacent collecting finger 210 of the same electropolarity. The arrangement of the broken grids 211 and the extension connection fingers 240 increases the coverage of the grid line structure 200 on the surface of the cell base 100, thereby improving the photoelectric conversion efficiency of the back contact photovoltaic cell.

In some embodiments, where broken grids 221 are disposed between side connection lines 320 and side welding portions 412, the extension connection finger 230 connects the broken grid 221 to a converging finger 220. The extension connection finger passes through the gap between a converging finger 220 of different electropolarity adjacent to the broken grid 221 and the side connection line 320. In some embodiments, where broken grids 221 are disposed on the side of side welding portions 412 close to the first edge 101 and are not disposed between side connection lines 320, the extension connection fingers 230 connect the broken grids 221 to collecting fingers 210, and the extension connection fingers 230 extends in the second direction Y on the side close to the first edge 101.

As shown in FIG. 2, which is a schematic structural diagram of a back contact photovoltaic cell according to another embodiment of the present disclosure. In other embodiments, the back contact photovoltaic cell further includes auxiliary connection lines 340. The auxiliary connection lines 340 are disposed on both sides of the cell base 100 close to the first edges 101. The auxiliary connection lines 340 extend in the second direction Y, traverse the central region 110, and are electrically connected to the side connection lines 320 on both sides. The collecting fingers 210 within the central region 110 extend through the auxiliary connection lines 340 of the same electropolarity, so that the auxiliary connection lines 340 are electrically connected to the collecting fingers 210 of the same electropolarity within the central region 110. With the arrangement of the auxiliary connection lines 340 through the central region, the carriers collected by the collecting fingers 210 can be transported effectively in the central region, avoiding issues of non-connection or poor connection caused by printing errors, thereby improving carrier transport efficiency.

The arrangement of the auxiliary connection lines 340 allows carriers collected by the at least one connection line structure 300 in the edge regions via the converging fingers 220 to be transmitted not only to the external circuit through the side welding portions 412 but also through the second welding structures 420 on the collecting fingers 210, reducing the overall internal resistance of the back contact photovoltaic cell, improving carrier transport efficiency, and thereby enhancing the photoelectric conversion efficiency of the back contact photovoltaic cell.

Furthermore, the auxiliary connection lines 340 and the collecting fingers 210 are connected in a crosswise manner. That is, the distance between the end of a collecting finger 210 (that is electrically connected to the auxiliary connection line 340) and the first edge 101 is less than the distance between the auxiliary connection line 340 and the first edge 101. This cross-connection structure ensures the connection effectiveness between the collecting fingers 210 and the auxiliary connection lines 340, avoiding issues of non-connection or poor connection caused by printing errors.

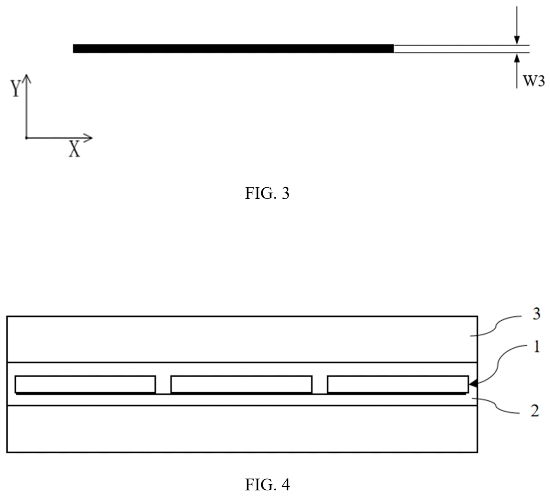

In the first direction X, the auxiliary connection lines 340 has a fifth width W5. The second width W2 of each side connection line 320, and the third width W3 (as shown in FIG. 3) of each collecting finger 210 and each converging finger 220 satisfy W2 > W5 > W3. The widths are set based on the carrier mobility collected and transported by the side connection lines 320, auxiliary connection lines 340, collecting fingers 210, and converging fingers 220. On one hand, this avoids the problem of high internal resistance due to uniformly small dimensions. On the other hand, it avoids the problem of excessive paste usage and increased production costs due to uniformly large dimensions. The width settings of the side connection lines 320, auxiliary connection lines 340, collecting fingers 210, and converging fingers 220 improve carrier transport efficiency, thereby enhancing the photoelectric conversion efficiency of the back contact photovoltaic cell, and reduce production costs.

In some embodiments, the fifth width W5 satisfies 30µm≤W5≤200µm. Preferably, the fifth width W5 may be 50µm, 70µm, 85µm, or 110µm.

Correspondingly, another embodiment of the present disclosure also provides a photovoltaic module. As shown in FIG. 4, the photovoltaic module includes a cell string 1, ribbons, an encapsulation film 2, and a cover plate 3. The cell string 1 is formed by connecting a plurality of back contact photovoltaic cells, which are the back contact photovoltaic cells described in the above embodiments. The ribbons connect adjacent back contact photovoltaic cells. The encapsulation film 2 covers the surfaces of the back contact photovoltaic cells. The cover plate 3 is disposed on the surface of the encapsulation film 2 away from the back contact photovoltaic cells. Parts that are the same as or correspond to those in the previous embodiment may be referred to the corresponding description in the foregoing embodiment, and detailed description will not be repeated here.

In some embodiments, where the cell base 100 is obtained by dividing a whole cell into 1/N pieces, the grid line structure 200, at least one connection line structure 300, and welding structures 400 are first formed on the surface of the whole cell by a screen printing process, and then the whole cell is divided into the N-piece cell base 100 of the embodiments of the present disclosure to construct the back contact photovoltaic cell. The ribbons connect adjacent back contact photovoltaic cells to form the cell string. In other embodiments, the cell base 100 is a whole cell, and the grid line structure 200, at least one connection line structure 300, and welding structures 400 are formed on the surface of the cell base 100 by a screen printing process to directly construct the back contact photovoltaic cell. The ribbons connect adjacent back contact photovoltaic cells to form the cell string.

The material of the encapsulation film may be ethylene-vinyl acetate (EVA) copolymer film, polyolefin elastomer (POE) film, polyvinyl butyral (PVB) film, or other organic encapsulation films.

The cover plate may be a glass cover plate, plastic cover plate, or other cover plates with light-transmitting function. In some embodiments, the surface of the cover plate facing the encapsulation film may be a textured surface to increase the utilization of incident light.

Those of ordinary skill in the art will understand that the above embodiments are specific embodiments for implementing the present disclosure. In practical applications, various changes can be made in form and details without departing from the spirit and scope of the present disclosure. Any person skilled in the art can make various changes and modifications without departing from the spirit and scope of the present disclosure. Therefore, the protection scope of the present disclosure shall be defined by the claims.

## Claims

1. A back contact photovoltaic cell, comprising:
a cell base (100) having a central region (110) and two edge regions (120) arranged on two opposing sides of the central region (110);
a plurality of first fingers (210) and a plurality of second fingers (220), wherein the plurality of the first fingers (210) are arranged in the central region (110), and the plurality of second fingers (220) are arranged in the two edge regions (120), wherein the plurality of the first fingers (210) extend in a first direction (X) and are arranged at intervals in a second direction (Y) that intersects with the first direction (X), wherein the two edge regions (120) are spaced apart in the second direction (Y); wherein the plurality of second fingers (220) include a plurality of first sets and a plurality of second sets alternately arranged at intervals in the second direction (Y), wherein second fingers (220) in a same set of the plurality of first sets and the plurality of second sets extend along a same straight line in the first direction (X) and adjacent second fingers (220) in the same set are spaced apart from each other in the first direction (X);
at least one middle connection line (310) and a pair of side connection lines (320) disposed in each of the two edge regions (120), wherein the at least one middle connection line (310) and the pair of side connection lines (320) extend in the second direction (Y); wherein the pair of the side connection lines (320) is disposed close to two opposing edges of the cell base (100) in the first direction (X), respectively, and the at least one middle connection line (310) is disposed between the pair of side connection lines (320) in a same edge region (120), wherein a respective connection line of the at least one middle connection line (310) and the pair of side connection lines (320) is electrically connected to second fingers (220) having a same electropolarity as the respective connection line in the plurality of second fingers (220); and
a pair of auxiliary connection lines (340), disposed close to the two opposing edges, extending in the second direction (Y) through the central region (110), and being electrically connected to the pair of side connection lines (320), respectively;
wherein, in the first direction (X), the pair of side connection lines (320) have a width greater than that of the pair of auxiliary connection lines (340).

2. A back contact photovoltaic cell, having a central region (110) and two edge regions (120) arranged on two opposing sides of the central region (110), and comprising:
at least one grid line structure including a first grid line structure disposed in the central region (110) and two second grid line structures respectively disposed in the two edge regions (120), wherein the first grid line structure includes a plurality of first fingers (210), the plurality of the first fingers (210) extend continuously in a first direction (X) and are arranged at intervals in a second direction (Y) intersecting the first direction (X), wherein the two edge regions (120) are spaced apart in the second direction (Y), wherein the second grid line structure includes at least one first set of second fingers (220) and at least one second set of second fingers (220) alternately arranged at intervals in the second direction (Y), wherein the first set of second fingers (220) and the second set of second fingers (220) respectively include a plurality of second fingers (220) that extend along a same straight line in the first direction (X) and are spaced apart;
two connection line structures disposed in the two edge regions (120), respectively, wherein the two connection line structures respectively include at least one middle connection line (310) and a pair of side connection lines (320), the at least one middle connection line (310) and the pair of side connection lines (320) extending in the second direction (Y), wherein the pair of the side connection lines (320) are disposed close to two opposing edges of the back contact photovoltaic cell in the first direction (X), respectively, and the at least one middle connection line (310) is disposed between the pair of side connection lines (320), wherein a respective connection line of the at least one middle connection line (310) and the pair of side connection lines (320) is electrically connected to second fingers (220) having a same electropolarity as the respective connection line in the at least one first set of second fingers (220) and the at least one second set of second fingers (220); and
a pair of auxiliary connection lines (340), disposed close to the two opposing edges, extending in the second direction (Y) through the central region (110) and being electrically connected to the pair of side connection lines (320), respectively;
wherein, in the first direction (X), the pair of side connection lines (320) have a width greater than that of the pair of auxiliary connection lines (340).

3. The photovoltaic cell according to claim 1, wherein in the first direction (X), the at least one middle connection line (310) has a width greater than that of the pair of side connection lines (320).

4. The photovoltaic cell according to claim 3, wherein, in the first direction (X), the at least one middle connection line (310) has a first width W1, the pair of side connection lines (320) has a second width W2; in the second direction (Y), the plurality of first fingers (210) and the plurality of second fingers (220) have a third width W3, satisfying W1>W2>W3, 400µm≥W1≥250µm, 250µm≥W2≥50µm, 50µm≥W3≥15µm.

5. The photovoltaic cell according to claim 1, further comprising a plurality of welding structures being electrically connected to the plurality of first fingers (210), the at least one middle connection line (310) or the pair of side connection lines (320), wherein the plurality of welding structures include:
a plurality of first welding structures (410) disposed in the two edge regions (120) close to the central region (110), and a respective first welding structure (410) of the plurality of first welding structures (410) being electrically connected to a connection line having a same electropolarity as the respective first welding structure (410) in the at least one middle connection line (310) and the pair of side connection lines (320);
a plurality of second welding structures (420) disposed in the central region (110) and having a first group of second welding structures (420) having first electropolarity and being electrically connected to first fingers (210) having the first electropolarity in the plurality of first fingers (210), and a second group of second welding structures (420) having second electropolarity and being electrically connected to first fingers (210) having the second electropolarity in the plurality of first fingers (210).

6. The photovoltaic cell according to claim 5, wherein, the adjacent second fingers (220) in the same set are spaced apart from each other in the first direction (X) by a gap (2201);
wherein the respective first welding structure (410) has two ends, respectively electrically connected to second fingers (220) having a same electropolarity as the respective first welding structure (410) in two adjacent sets that are closest to the central region (110) in the plurality of first sets and the plurality of second sets, or wherein the respective first welding structure (410) has one end, electrically connected to second fingers (220) having a same electropolarity as the respective first welding structure (410) in a first set that is closest to the central region (110) in the plurality of first sets and the plurality of second sets, and the other end, electrically connected to a first finger (210) having a same electropolarity as the respective first welding structure (410) and being closest to the edge regions (120) in the plurality of first fingers (210);
wherein the respective first welding structure (410) extends in the second direction (Y) from the one end to the other end through the gap (2201) between adjacent second fingers (220) having a different electropolarity from the respective first welding structure (410) in a second set that is closest to the central region (110) in the plurality of first sets and the plurality of second sets.

7. The photovoltaic cell according to claim 5 or claim 6, wherein the plurality of first welding structures (410) include at least one middle welding portion (411) and a pair of side welding portions (412), the at least one middle welding portion (411) is electrically connected to the at least one middle connection line (310), respectively, and the pair of side welding portions (412) is electrically connected to the pair of side connection lines (320), respectively;
wherein the photovoltaic cell further comprises extension connection lines (330), each electrically connected a respective side welding portion (412) of the pair of side welding portions (412) to a corresponding side welding portion (412) of the pair of side connection lines (320);
wherein a distance between the respective side welding portion (412) and a first edge (101) closest to the respective side welding is greater than a distance between the corresponding side connection line (320) and the first edge (101).

8. The photovoltaic cell according to claim 7, wherein, in the second direction (Y), the middle welding portion (411) has a third length L3, the side welding portion (412) has a fourth length L4, where L4 > L3.

9. The photovoltaic cell according to claim 7, wherein, in the second direction (Y), the side welding portion (412) has a fourth length L4, a spacing dimension between adjacent first fingers (210) or adjacent second fingers (220) is a spacing length G, wherein 4×G>L4>2×G.

10. The photovoltaic cell according to claim 1, wherein, in the first direction (X), the side connection line (320) has a second width W2 and the auxiliary connection line (340) has a fifth width W5, wherein, 250µm≥W2≥50µm, 200µm ≥ W5 ≥ 30µm.

11. The photovoltaic cell according to claim 7, wherein, the plurality of second fingers (220) include:
a first broken grid, disposed on a side of the respective side welding portion (412) facing the first edge (101), and
a first extension connection finger, extending in the second direction (Y) and disposed on the side of the respective side welding portion (412) facing the first edge (101), and being electrically connected to the broken grid and a second finger (220) having a same electropolarity as the first extension connection finger, respectively.

12. The photovoltaic cell according to claim 1, wherein two end edges of the cell base extending in the second direction (Y) are first edges (101), and two end edges of the cell base extending along the first direction (X) are second edges;
wherein a distance between a first end of the respective connection line and a corresponding second edge closest to the first end in the second direction (Y) is less than a distance from the corresponding second edge to a second finger (220) electrically connected to the respective connection line and closest to the corresponding second edge in the plurality of second fingers (220); and
wherein a distance between a second end of a second finger (220) electrically connected to a respective side connection line (320) in the first direction (X) and a corresponding first edge (101) closest to the second end is less than a distance between the side connection line (320) and the corresponding first edge (101).

13. The photovoltaic cell according to claim 1, wherein a respective auxiliary connection line (340) of the pair of auxiliary connection lines (340) is electrically connected to first fingers (210) having a same electropolarity as the respective auxiliary connection line (340) in the plurality of first fingers (210).

14. The photovoltaic cell according to claim 13, wherein, two end edges of the cell base extending in the second direction (Y) are first edges (101), two end edges of the cell base extending in the first direction (X) are second edges; and
wherein a distance between a third end of the first fingers (210) electrically connected to the respective auxiliary connection line (340) and a corresponding first edge (101) closest to the respective auxiliary connection line (340) in the second direction (Y) is less than a distance between the auxiliary connection line (340) and the corresponding first edge (101).

15. A photovoltaic module, comprising:
at least one cell string (1) formed by connecting a plurality of back contact photovoltaic cells, each of the plurality of back contact photovoltaic cells is the back contact photovoltaic cell according to any one of claims 1-14;
ribbons configured for connecting adjacent back contact photovoltaic cells of the plurality of back contact photovoltaic cells;
at least one encapsulant film (2) configured to cover surfaces of the plurality of back contact photovoltaic cells; and
at least one cover plate (3) disposed on a surface of the at least one encapsulant film (2) away from the plurality of back contact photovoltaic cells.
